(19) Europäisches Patentamt
European Patent Office
Office européen des brevets

(11) **EP 1 188 235 B1**

(12) **EUROPÄISCHE PATENTSCHRIFT**

(45) Veröffentlichungstag und Bekanntmachung des Hinweises auf die Patenterteilung:
**10.05.2006 Patentblatt 2006/19**

(21) Anmeldenummer: **00945619.5**

(22) Anmeldetag: **08.06.2000**

(51) Int Cl.:
*H03H 7/46* (2006.01)    *H01F 1/153* (2006.01)

(86) Internationale Anmeldenummer:
**PCT/DE2000/001875**

(87) Internationale Veröffentlichungsnummer:
**WO 2000/077928 (21.12.2000 Gazette 2000/51)**

(54) **HOCHPASSZWEIG EINER FREQUENZWEICHE FÜR ADSL-SYSTEME**

HIGH-PASS BRANCH OF A FREQUENCY SEPARATING FILTER FOR ADSL SYSTEMS

BRANCHE PASSE-HAUT D'UN DIPLEXEUR POUR SYSTEMES LNPA

(84) Benannte Vertragsstaaten:
**DE ES FR GB IT**

(30) Priorität: **11.06.1999 DE 19926699**

(43) Veröffentlichungstag der Anmeldung:
**20.03.2002 Patentblatt 2002/12**

(73) Patentinhaber: **Vacuumschmelze GmbH**
**63450 Hanau (DE)**

(72) Erfinder:
• **PETZOLD, Joerg**
**D-63486 Bruchköbel (DE)**
• **BEICHLER, Johannes**
**D-63110 Rodgau (DE)**
• **HEUMANN, Dirk**
**D-61130 Nidderau (DE)**

(74) Vertreter: **Schmuckermaier, Bernhard et al**
**Westphal & Partner**
**Mozartstrasse 8**
**80336 München (DE)**

(56) Entgegenhaltungen:
**EP-A- 0 299 498**    **EP-A- 0 637 038**
**EP-A- 0 677 938**    **WO-A-97/11534**
**WO-A-97/48206**    **WO-A-98/12847**
**US-A- 5 074 932**

## Beschreibung

Die Erfindung betrifft eine Frequenzweiche mit einem Tiefpaßzweig für niederfrequente Signale insbesondere analoger Kommunikationssysteme und mit einem Hochpaßzweig für hochfrequente Signale digitaler Kommunikationssysteme mit einer Vielzahl von induktiven Bauelementen mit Magnetkernen. Eine solche Frequenzweiche ist beispielsweise aus des EP 0 677 938 bekannt.

Als Magnetkerne wurden bisher RM4, RM6, RM8 sowie andere Ferrit-Schalenkerne aus Kernwerkstoffen wie beispielsweise N27 und N48 eingesetzt. Die erforderliche Klirrfaktoranforderung wurde dabei mittels Scherung durch Schlitzen des Magnetkerns erreicht.

Ein Nachteil der Scherung ist, daß sie einen Rückgang der effektiv wirksamen Kernpermeabilität bis auf Werte um 200 bewirkt. Zum Erreichen der erforderlichen Hauptinduktivität, der niedrigen Einfügedämpfung im Sperrbereich und der erforderlichen Aussteuerbarkeit muß beim Hochpaßzweig mit Ferritkernen konstruktionsbedingt das Volumen sehr groß ausgelegt werden, so daß aus Ferritkernen hergestellte Hochpaßzweige viel Platz in Anspruch nehmen. Aus den wegen der niedrigen Permeabilität hohen Windungszahlen von primär- und sekundärseitiger Bewicklung der Ferritlösungen resultieren weiterhin hohe Koppel- und Wicklungskapazität und Streuinduktivität, die zu Störeffekten führen können.

Ausgehend von diesem Stand der Technik liegt der Erfindung die Aufgabe zugrunde, eine Frequenzweiche zu schaffen, deren Hochpaßzweig für Hochfrequenzsignale digitaler Kommunikationssysteme geeignet ist und ein geringes Bauvolumen aufweist.

Diese Aufgabe wird durch eine Frequenzweiche mit der Merkmalen der Ansprüche 1, 3 oder 5 gelöst.

Nanokristalline, weichmagnetische Legierungen weisen im Vergleich zu Ferriten eine wesentlich höhere Permeablität auf. Es ist jedoch schwierig, Magnetkerne aus einer amorphen oder nanokristallinen, weichmagnetischen Legierung so herzustellen, daß die Hystereseschleife die für den Einsatz in digitalen Breitbandkommunikationssystemen erforderliche Linearität aufweist. Ein hohes Maß an Linearität ist aber erforderlich, um die gestellten Anforderungen an den Klirrfaktor zu erfüllen. Da jedoch die magnetische Aussteuerung des Magnetkerns mit zunehmenden Frequenzen abnimmt, sind bei großen Aussteuerungen auftretende Abweichungen von einer idealen linearen Hystereseschleife für hohe Frequenzen unschädlich. Demnach ist es möglich, für die induktiven Bauelemente im Hochpaßzweig der Filterweiche amorphe oder nanokristalline weichmagnetische Legierungen vorzusehen.

Für die Verwendung im Hochpaßzweig der Frequenzweiche bevorzugte Legierungen sind Gegenstand der abhängigen Ansprüche.

Im folgenden wird die Erfindung im einzelnen anhand der beigefügten Zeichnung beschrieben. Es zeigen:

Figur 1          eine Übersicht über die Verbindung zwischen einer Ortsvermittlungsstelle und einem teilnehmerseitigen Netzabschluß;

Figur 2          eine Frequenzweiche, die einen Hochpaßzweig und einen Tiefpaßzweig aufweist;

Figur 3          3 ein Diagramm, das beispielhaft die Abhängigkeit des Frequenzgangs der Permeabilität von der Dicke der für die Herstellung eines Magnetkerns verwendeten Bänder zeigt;

Figur 4          ein weiteres Diagramm, das die Abhängigkeit des Frequenzgangs der Permeabilität von der Breite eines in einem Magnetkern eingebrachten Schlitzes darstellt;

Figur 5          eine Darstellung der auf die Permeabilität bei Raumtemperatur bezogenen Permeablitätsänderungen in Abhängigkeit von der Temperatur;

Figur 6          eine Darstellung des Frequenzgangs des Verlustwiderstands Rp im Parallelersatzschaltbild von Spulen, die Magnetkerne aus einer amorphen Legierung aufweisen;

Figur 7          eine Darstellung des Frequenzgangs der Einfügungsdämpfung der Spulen aus Figur 6;

Figur 8          eine Darstellung der Gleichfeldvorbelastbarkeit von Magnetkernen aus verschiedenen amorphen und nanokristallinen Legierungen;

Figur 9          eine Hystereseschleife mit nahezu idealer Linearität; und

Figuren 10-15    beispielhafte Wärmebehandlungen.

Da VDSL-Systeme noch nicht in allen Details festgelegt sind werden im folgenden insbesondere induktive Bauelemente des ADSL-Systems beschrieben. Nach heutigem Kenntnisstand ist davon auszugehen, daß die Anforderungen an die induktiven Bauelemente für VDSL-Systeme denen des ADSL-Systems weitgehend entsprechen.

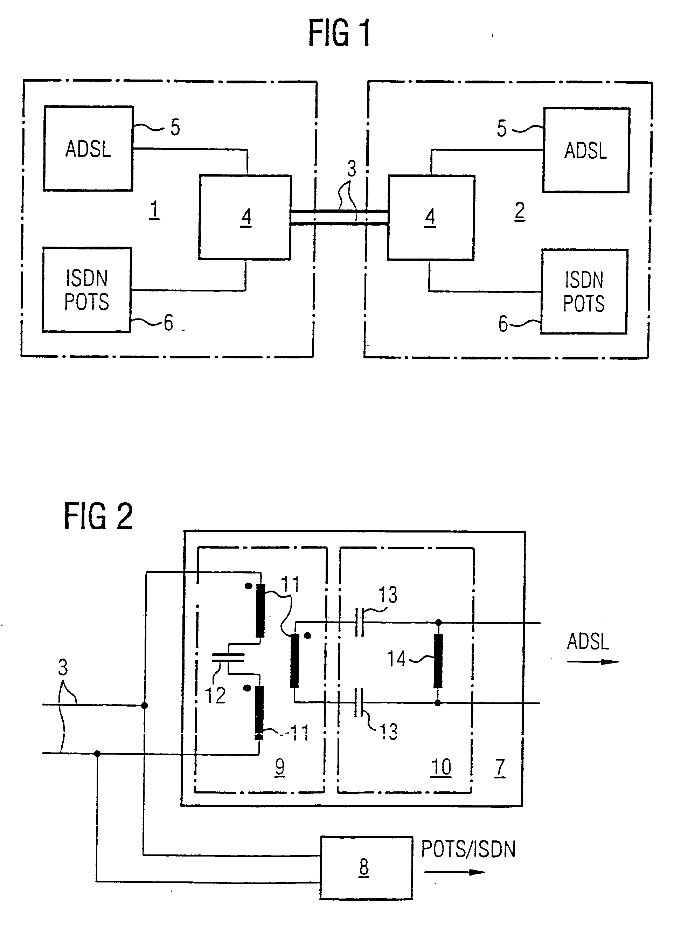

Wie in Fig 1 dargestellt, erfolgt im ADSL(Asymmetric Digital Subscriber Line)-Telekommunikationssystem die Verbindung zwischen einer ADSL-fähigen digitalen Ortsvermittlungsstelle 1 und einem teilnehmerseitiger Netzabschluß 2 (ADSL-Modem) über eine öffentliche Zweidrahtleitung 3. Zeitgleich mit den ADSL-Daten können über dieselbe Zweidrahtleitung 3 POTS(plain old telephone system)- oder ISDN(Integrated Services Digital Network)-Verbindurgen laufen. Die Trennung und Übertragung der niederfrequenten (POTS, ISDN) und der hochfrequenten Komponenten (ADSL) wird durch Frequenzweichen 4 bewirkt, die an den Enden der öffentlichen Zweidrahtleitung 3 sitzen.

Die über die öffentliche Zweidrahtleitung 3 laufenden hochfrequenten ADSL-Signale werden von den Frequenzweichen 4 in einen ADSL-Zweig 5 gelenkt, während die niederfrequenten POTS- und ISDN-Signale von den Frequenzweichen 4 jeweils in POTS-/ISDN-Zweige 6 gelenkt werden. Die Frequenzweichen 4 umfassen demzufolge einen Hochpaßzweig 7 und einen Tiefpaßzweig 8. Bei dem in Figur 2 dargestellten Ausführungsbeispiel wird der Hochpaßzweig 7 von einem Hochpaßübertrager 9 und nachgeschalteten Hochpaßfilterkomponenten 10 gebildet. Der Hochpaßübertrager 9 weist drei auf einen gemeinsamen Magnetkern aufgewickelte Spulen 11 und einen zwischen die primärseitigen Spulen 11 geschalteten Kondensator 12 auf. Die nachgeschalteten Hochpaßfilterkomponenten 10 umfassen Kondensatoren 13 und eine Hochpaßfilterdrossel 14. Die Induktivitäten des Hochpaßübertragers 9 und die Hochpaßfilterdrossel 14 werden nachfolgend kurz als die induktiven Bauelemente des Hochpaßzweigs 7 bezeichnet.

Es sei angemerkt, daß neben dem in Figur 2 dargestellten Ausführungsbeispiel weitere Ausführungsformen des Hochpaßzweiges 7 denkbar sind.

So sind die hier vorgestellten induktiven Bauelemente auch in anderen Ausführungsformen des Hochpaßzweig 7, zum Beispiel bei einem elliptischen oder Invers-Tschebyscheff-Hochpaßzweig 7, einsetzbar.

Je nach dem Übertragungssystem unterscheidet man das DMT-System (discrete multitone) und das CAP-System (carrierless amplitude phase modulation). Die Codierungen haben Auswirkungen auf die spektrale Verteilung des Magnetisierungsstromes des Hochpaßzweigs 7 in der Frequenzweiche 4.

Man muß ferner ADSL-Systeme über POTS und ISDN unterscheiden, die verschiedene untere Grenzfrequenzen (POTS: ca. 30 kHz, ISDN: ca. 140 kHz) haben. Nachfolgend wird deshalb zwischen ADSL-POTS-Splittern und ADSL-ISDN-Splittern unterschieden. Aufgrund der niedrigeren Grenzfrequenzen und den höheren Spannungsamplituden bei POTS bekommt man eine stärkere Aussteuerung der induktiven Bauelemente des Hochpaßzweiges 7 bei POTS als bei ISDN. Die Magnetkerne der induktiven Bauelemente des Hochpaßzweiges 7 dürfen aber aufgrund der $U_{ac}$-Aussteuerung weder in Sättigung gehen noch dürfen sie so weit ausgesteuert werden, daß systemspezifische Eigenschaften, die in den einschlägigen Normen festgelegt sind, nicht mehr erfüllt werden.

An die auf beiden Seiten der öffentlichen Zweidrahtleitung 3 im Hochpaßzweig 7 eingesetzten induktiven Bauelemente werden deshalb die folgenden Anforderungen gestellt:

a)minimales Bauvolumen
b)Eignung für die Übertragungscodesysteme

- DMT

- CAP

- QAM / MQAM ((Multiple) Quadrature Amplitude Modulation)

c)Hauptinduktivitäten < 2 mH je nach Filterauslegung, im allgemeinen < 0.5 mH, bevorzugt <0,1 mH
d)Wechselspannungsaussteuerung der Induktivitäten

- bei hohen Frequenzen durch ADSL-Signale (ab 20 kHz, bis 45Vpp)
- bei niedrigeren Frequenzen durch POTS- und ISDN-Signale mit typischen Pegeln gemäß 1TR110 und ETR80

e)Loops nach ANSI T1E1.413 und ETSI ETR 328
f)geringes Kerngewicht und SMD-Fähigkeit
g)Ringkernform, dadurch einfachere Sicherheitsanforderungen nach IEC 950
h)geringe Einfügedämpfung im ADSL-Durchlaßbereich (zur Zeit > 30kHz (POTS) oder > 140 kHz (ISDN) bis 1,1 MHz, eventuell bis 1,8 MHz), hohe Einfügedämpfung im ADSL-Sperrbereich (zur Zeit < 20 kHz (POTS) oder < 100 kHz (ISDN))
i)geringer und monotoner Temperaturgang der relevanten magnetischen Kenngrößen im Bereich -40°C - 100°C.

Bei der vorliegenden Erfindung handelt es sich um induktive Bauelemente für den Hochpaßzweig 7 in ADSL-POTS-Splittern und ADSL-ISDN-Splittern, die statt eines Ferritkerns einen kleinen Metallbandkern aus einer amorphen oder nanokristallinen Legierung enthalten. Dieser erhält seine normgerechten Eigenschaften durch eine optimierte Kombination aus Banddicke, Legierung und Wärmebehandlung im Magnetfeld sowie kerntechnologische Fertigungsschritte.

Eine erste grundlegende Anforderung ist, daß die Permeabilität der Kernmaterialien der induktiven Bauelemente im Hochpaßzweig 7 über den gesamten ADSL-Frequenzbereich weitestgehend konstant bleibt. Diese Anforderung wurden folgendermaßen erfüllt:

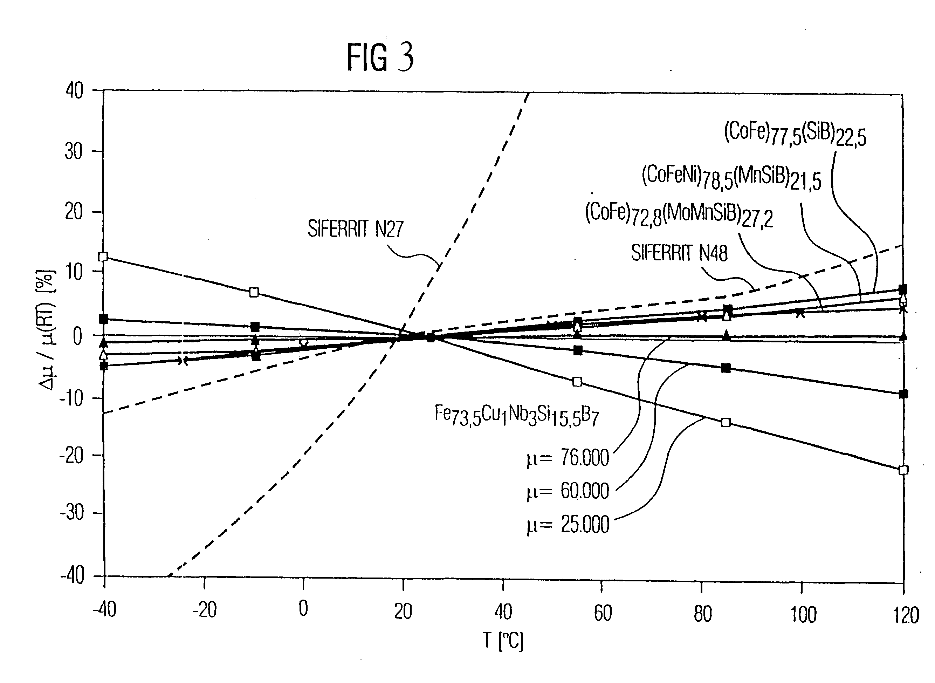

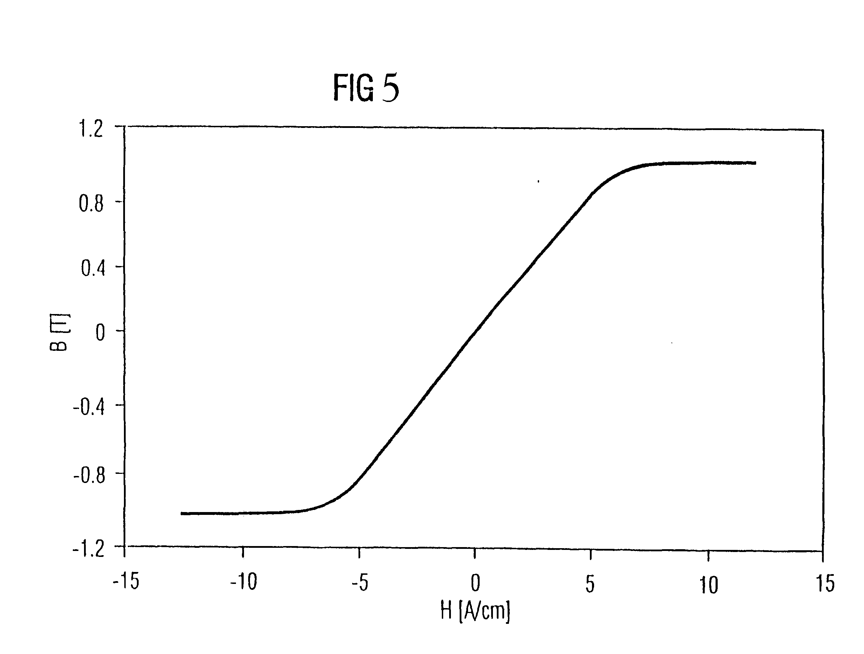

Magnetkerne, die aus niederpermeablen ($\mu < 2500$) Legierungen hergestellt werden, sind vorzugsweise ungeschlitzt. Die erforderlichen Frequenzeigenschaften werden dabei über den spezifischen elektrischen Widerstand $\rho$ der Legierung und die Banddicke $d_{Band}$ eingestellt. Wie aus Fig. 3 hervorgeht, sollte $d_{Band} < 30\mu m$, vorzugsweise $< 20\mu m$, möglichst $< 17\mu m$ oder noch kleiner sein, damit die Permeabilität der Kernmaterialien im relevanten Frequenzbereich weitestgehend konstant bleibt. Gemäß Fig. 5, bleiben diese $\mu(f)$ - Eigenschaften der hier verwendeten, wärmebehandelten Werkstoffe über einen weiten Temperaturbereich stabil.

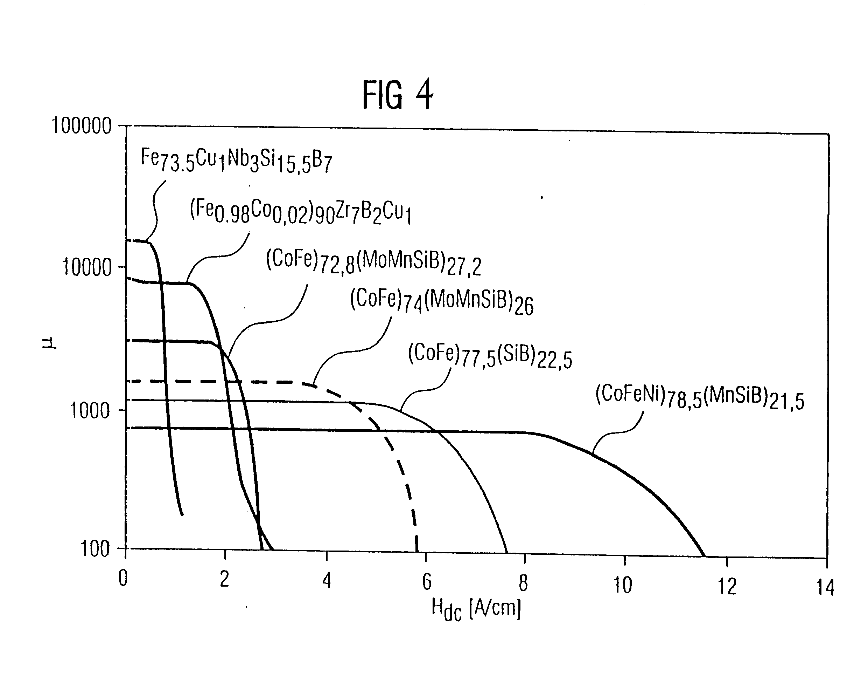

Wenn die Magnetkerne dagegen aus höherpermeablen Legierungen ($\mu \geq 2500$, vorzugsweise $\mu \geq 10000$) hergestellt werden, so läßt sich entsprechend Fig. 4 der Frequenzgang der der Permeabilität $\mu$ und damit der der Induktivität L durch Einbringung eines Schlitzes in angepaßter Breite wesentlich verbessern. Die Schlitzbreite $d_{Schlitz}$ hängt dabei wiederum von der Kombination Legierung/Wärmebehandlung ab. Typische Breiten liegen im Bereich 1 bis 200 $\mu m$.

Eine zweite grundlegende Anforderung ist, daß die Einfügungsdämpfung im Hochpaßzweig 7 über den gesamten ADSL-Frequenzbereich hinweg entsprechend ANSI T1E1.413 möglichst gering ist. Für das Gesamtsystem, bestehend aus zwei ADSL-Modems, muß im 100-Ohm oder 135-Ohm-System ohne Berücksichtigung der Leitung $a_E < 1$ dB gelten, wobei $a_E$ die Einfügungsdämpfung ist. Dabei nimmt für einen vorgegebenen Wellenwiderstand die Einfügungsdämpfung mit zunehmendem Wert für $R_p$ ab. $R_p$ ist dabei der ohmsche Widerstand im Parallelersatzschaltbild für das induktive Bauelement, der die Ummagnetisierungsverluste im Magnetkern sowie die ohmschen Kupferverluste der Bewicklung repräsentiert. Dabei gilt der Zusammenhang

$$R_p(f) \; = \; 2*\pi^2*N^2*(1/\rho_{mech}) * (A_{Fe}/l_{Fe})*f^2*B^2/P_{Fe}(f) \qquad\qquad (1)$$

wobei N die Anzahl der Windungen, $\rho_{mech}$ die spezifische Dichte des Magnetkerns, $A_{Fe}$ die Querschnittsfläche des Magnetkerns $l_{Fe}$ die Eisenweglänge, B die magnetische Induktions und $P_{Fe}(f)$ den Frequenzgang der spezifischen Gesamtverluste bezeichnet, die ihrerseits wiederum von den Hysterese- und von den Bandeigenschaften abhängen.

Die Einfügungsdämpfung $a_E$ hängt in der oben beschriebenen Weise vor allem im Bereich niedriger und mittlerer Frequenzen allein von dem Verlustwiderstand Rp ab. Die niedrigen Ummagnetisierungsverluste und die wegen der kleinen notwendigen Windungszahlen geringen Werte des Wicklungswiderstandes $R_{ou}$ führen daher im unteren und mittleren Frequenzbereich zu einer niedrigen Einfügungsdämpfung $a_E$. Bei hohen Frequenzen kommt zusätzlich die Tatsache zum Tragen, dass metallische Ringbandkerne besonders niedrige Streuinduktivitäten ermöglichen, so dass sich Übertrager mit einem solchen Ringbandkern auch hier durch besonders geringe Einfügedämpfungswerte und hohe Reflexionsdämpfungswerte $a_R$ auszeichnen. Auch die wegen den kleinen notwendigen Windungszahlen niedrigen realisierbaren Wicklungskapazitäten führen im Bereich hoher Frequenzen zu günstigen $a_E$-Werten und $a_R$-Werten. Im Ergebnis weisen metallische Ringbandkerne daher im gesamten Frequenzbereich diesbezüglich besonders günstige Eigenschaften auf.

Zusammenfassend kann festgehalten werden, daß sich gerade durch die Kombination aus extrem linearer Hystereseschleife und dünnen Bändern der hier verwendeten, wärmebehandelten Legierungen mit hohem spezifischen elektrischen Widerstand ADSL-Hochpaßzweige 7 mit besonders kleinen Einfügungsdämpfungen herstellen lassen.

Noch weiter verbessern läßt sich der $R_p$-Wert durch eine Beschichtung von mindestens einer Bandoberfläche mit einem elektrisch isolierenden Medium, das eine kleine Dielektrizitätszahl von $\in_r < 10$ besitzen muß. Eine andere Möglichkeit zur Verschiebung des verlustbedingten Permeabilitätsabfalls, wird durch die definierte Einstellung der Permeabilität innerhalb bestimmter Grenzen auf möglichst niedrigem Niveau oder durch Einbringen eines angepaßten Schlitzes erzielt. Die normgerechten Eigenschaften von induktiven Bauelementen für den Hochpaßzweig 7 lassen sich am besten mit amorphen, nahezu magnetostriktionsfreien Kobalt-Basis-Legierungen sowie mit praktisch magnetostriktionsfreien feinkristallinen Legierungen erreichen. Letztere werden üblicherweise als "nanokristalline Legierungen" bezeichnet und sind durch ein extrem feines Korn mit einem mittleren Durchmesser von weniger als 100 nm gekennzeichnet, das mehr als 50 % des Materialvolumens einnimmt. Eine wichtige Voraussetzung ist, daß die Induktivitäten eine hohe Sättigungsinduktion von $B_s > 0,6$ T, vorzugsweise $> 0,9$ T, besser $> 1$ T, und eine sehr lineare Hystereseschleife mit einem Sättigungs- zu Remanenzverhältnis $B_r/B_s < 0,2$ , vorzugsweise $< 0,08$, besitzen.In diesem Zusammenhang zeichnen sich die magnetostriktionsfreien nanokristallinen Werkstoffe auf Fe-Basis durch eine besonders hohe Sättigungsinduktion von 1,1 T oder mehr aus. Eine Aufzählung sämtlicher betrachteter und erfindungsgemäß für geeignet befundener Legierungssysteme findet sich weiter unten.

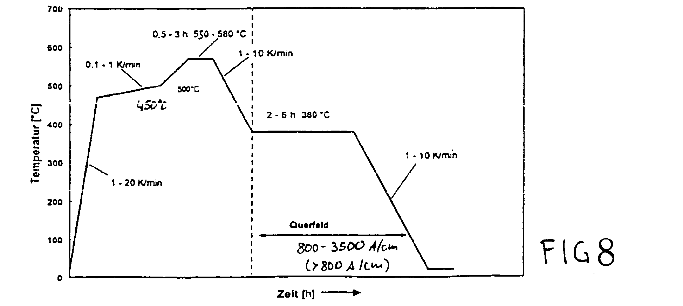

Die dritte grundsätzliche Voraussetzung für das Erreichen der im Hochpaßzweig von ADSL-POTS- oder ADSL-ISDN-Splittern geforderten Eigenschaften ist ein ausgeprägtes Linearitätsverhalten der Hystereseschleifen, wie dies zum Beispiel in Fig. 8 und 9 dargestellt ist. Solche linearen Hystereseschleifen lassen sich beispielsweise durch die nachfolgend beschriebenen Fertigungsgänge erreichen:

Das mittels Rascherstarrungstechnologie hergestellte weichmagnetische amorphe Band der Dicke d < 30 $\mu$m, vorzugsweise < 20 $\mu$m, besser < 17 $\mu$m, aus einer der unten aufgezählten Legierungen wird auf speziellen Maschinen spannungsfrei zum Magnetkern in dessen Endabmessung gewickelt. Alternativ kommen hierbei aber auch Magnetkerne in Frage, die aus einem Stapel gestanzter Scheiben aus besagten Legierungen aufgebaut sind.

Wie bereits erwähnt, lassen sich die normgerechten Anforderungen an die Frequenzeigenschaften dann noch besser erfüllen, wenn das Band vor dem Wickeln des Magnetkerns, insbesondere vor dem Stanzen der Scheiben, auf einer Seite oder auf zwei Seiten elektrisch isolierend beschichtet wird. Hierfür wird, je nach Anforderungen an die Güte der Isolationsschicht, ein Tauch-, Durchlauf-, Sprüh- oder Elektrolyseverfahren am Band eingesetzt. Dasselbe kann aber auch durch Tauchisolation des gewickelten oder gestapelten Magnetkerns erreicht werden. Bei der Auswahl des isolierenden Mediums ist darauf zu achten, daß dieses einerseits auf der Bandoberfläche gut haftet, andererseits keine Oberflächenreaktionen verursacht, die zu einer Schädigung der Magneteigenschaften führen können. Bei den hier erfindungsgemäß eingesetzten Legierungen haben sich Oxide, Acrylate, Phosphate, Silikate und Chromate der Elemente Ca, Mg, Al, Ti, Zr, Hf, Si als wirkungsvolle und verträgliche Isolatoren herausgestellt. Besonders effektiv war dabei Mg, welches als flüssiges magnesium-haltiges Vorprodukt auf die Bandoberfläche aufgebracht wird, und sich während einer speziellen, die Legierung nicht beeinflussenden Wärmebehandlung in eine dichte Schicht aus MgO umwandelt, deren Dicke zwischen 50 nm und 1 $\mu$m liegen kann.

Bei der anschließenden Wärmebehandlung der isolierten oder unisolierten Magnetkerne zur Einstellung der weichmagnetischen Eigenschaften ist zu unterscheiden, ob der Magnetkern aus einer Legierung besteht, die sich zur Einstellung einer nanokristallinen Struktur eignet oder nicht.

Magnetkerne aus Legierungen, die sich zur Nanokristallisation eignen, werden zur Einstellung des nanokristallinen Gefüges einer exakt abgestimmten Kristallisationswärmebehandlung unterzogen, die je nach Legierungszusammensetzung zwischen 440 °C und 690 °C liegt. Typische Haltezeiten liegen zwischen 4 Minuten und 8 Stunden. Je nach Legierung ist diese Kristallisationswärmebehandlung im Vakuum oder im passiven oder reduzierenden Schutzgas durchzuführen. In allen Fällen sind materialspezifische Reinheitsbedingungen zu berücksichtigen, die fallweise durch entsprechende Hilfsmittel wie elementspezifische Absorber- oder Gettermaterialien herbeizuführen sind. Dabei wird durch eine exakt abgeglichene Temperatur- und Zeitkombination ausgenutzt, daß sich bei den hier verwendeten Legierungszusammensetzungen gerade die Magnetostriktionsbeiträge von feinkristallinem Korn und amorpher Restphase ausgleichen und die erforderliche Magnetostriktionsfreiheit $|\lambda_s|$ < 2 ppm, vorzugsweise sogar $|\lambda_s|$ < 0,2 ppm, entsteht. Je nach Legierung und Ausführungsform des Bauelements wird entweder feldfrei oder im Magnetfeld längs zur Richtung des gewickelten Bandes ("Längsfeld") oder quer dazu ("Querfeld") getempert. In bestimmten Fällen kann auch eine Kombination aus zwei oder sogar drei dieser Magnetfeldkonstellationen zeitlich hintereinander oder parallel nötig werden. Besonders flache und lineare Schleifen wurden dann erreicht, wenn die Magnetkerne stirnseitig exakt so aufgestapelt sind, daß die Stapelhöhe mindestens das 10-fache, vorzugsweise wenigstens das 20-fache des Kernaußendurchmessers betrug und wenn bereits während der beschriebenen Kristallisationswärmebehandlung ein starkes Querfeld anlag. Die Hystereseschleife wurde dabei in der Regel umso flacher, je höher die Querfeldtemperatur angesetzt wurde, wobei das Überschreiten der legierungsspezifischen Curietemperaturen sowie die Entstehung unmagnetischer Phasen wie zum Beispiel Fe-Boride eine obere Grenztemperatur festlegt.

Die magnetischen Eigenschaften, das heißt die Linearität und die Steigung der Hystereseschleife, können - falls nötig - weiträumig durch eine zusätzliche Wärmebehandlung in einem Magnetfeld, das parallel zur Rotationssymmetrieachse des Magnetkerns - also rechtwinklig zur Bandrichtung - steht, variiert werden. Je nach Legierung und einzustellendem Permeabilitätsniveau sind dabei Temperaturen zwischen 350 °C und 690 °C erforderlich. Aufgrund der Kinetik der atomaren Reorientierungsvorgänge sind normalerweise die resultierenden Permeabilitätswerte umso niedriger, je höher die Querfeldtemperatur ist. Typische Kennlinien verschiedener geeigneter nanokristalliner Magnetlegierungen, die deren Linearitätsverhalten zum Ausdruck bringen, sind der Fig. 4 zu entnehmen. Diese Magnetfeld-Wärmebehandlung wurde entweder direkt mit der Kristallisationswärmebehandlung kombiniert oder separat durchgeführt. Für die Glühatmosphäre galten dieselben Bedingungen wie bei der Kristallisationswärmebehandlung zur Einstellung der nanokristallinen Struktur.

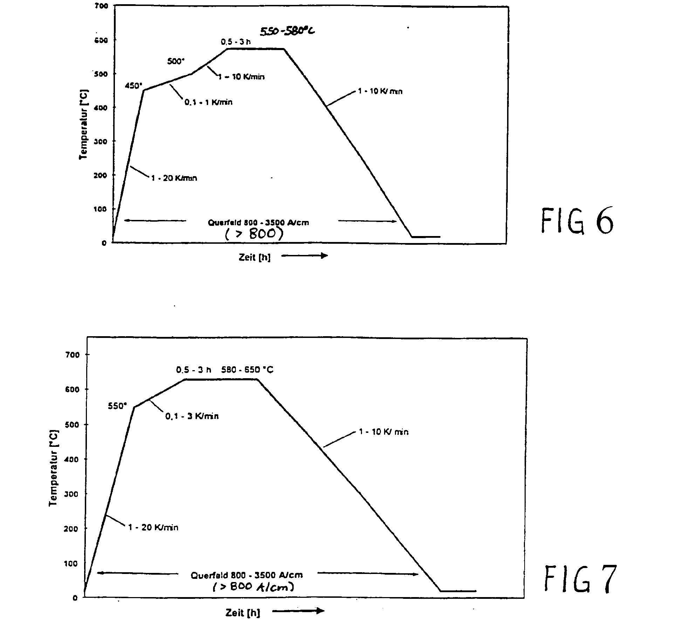

Als besonders gut hat es sich erwiesen, nanokristalline Legierungen, deren Permeabilitäten im Bereich zwischen $\mu$ = 13.000 und $\mu$ = 20.000 liegen, folgender Wärmebehandlung zu unterwerfen. Die Kerne werden zunächst von Raumtemperatur auf eine Temperatur, die ungefähr 450°C oder höher ist, mit einer Aufheizrate von 1 bis 20 K/min. erwärmt und anschließend nach Erreichen der Zieltemperatur von 450°C oder etwas höher mit einer langsamen Aufheizrate von 0,1 bis 1 K/min. bzw. mit einer Aufheizrate von 1 bis 10 K/min. auf eine Zieltemperatur von 550°C bis 580°C aufgeheizt und bei dieser Temperatur für eine Zeitdauer von 0,5 bis 3 h belassen. Danach werden die Kerne mit einer Abkühlrate von 1 bis 10 K/min. auf Raumtemperatur abgekühlt. Die gesamte Wärmebehandlung erfolgt typischerweise in einem Querfeld von einer Stärke von 800 bis 3500 A/cm. Dieses Beispiel einer Wärmebehandlung ist in der Figur 6 veranschaulicht. Sie wurde unter anderem erfolgreich an Magnetkernen aus einer nanokristallinen Legierung mit der chemischen Zusammensetzung $Fe_{73,5}Cu_1Nb_3Si_{15,5}B_7$ durchgeführt. Da die Magnetkerne hochpermeabel waren, das heißt eine Permeabilität von ungefähr 15.000 aufwiesen, wurden sie anschließend durch Schlitzen magnetisch geschert. Solche nanokristallinen Legierungen sind beispielsweise aus des EP-A-0 299 498 und der EP-A-0 65038 bekannt.

Bei nanokristallinen Legierungen, die im Vergleich zu den oberen nanokristallinen Legierungen relativ niederpermeabel sind, das heißt also Permeabilitäten von weniger als 15.000 aufweisen, hat sich die folgende Wärmebehandlung als besonders geeignet erwiesen. Die Magnetkerne werden zunächst von der Raumtemperatur mit einer Aufheizrate zwischen 1 und 20 K/min. auf eine Temperatur von ungefähr 550°C erwärmt und anschließend mit einer Aufheizrate von 0,1 bis 3 K/min. auf eine Zieltemperatur von 580°C bis 650°C aufgeheizt. Die Magnetkerne werden bei dieser Zieltemperatur für eine Zeitdauer von 0,5 bis 3 h belassen. Anschließend werden die Magnetkerne mit einer Abkühlrate von 1 bis 10 K/min. auf die Raumtemperatur wieder abgekühlt. Die gesamte Wärmebehandlung wird vorzugsweise in einem Querfeld von einer Stärke von 800 bis 3500 A/cm durchgeführt. Dieses Beispiel einer Wärmebehandlung ist in der Fig. 7 dargestellt. Die so erlangten Magnetkerne sind aufgrund ihrer relativ hohen Permeabilität anschließend durch Schlitzen magnetisch zu scheren. Diese Wärmebehandlung wurde unter anderem erfolgreich an nanokristallinen Legierungen der chemischen Zusammensetzung $(Fe_{0,98}Co_{0,02})_{90}Zr_7B_2Cu_1$, an der Legierung $Fe_{84}Zr_{3,5}Nb_{3,5}B_8Cu_1$ sowie an der Legierung $Fe_{84}Nb_7B_9$ durchgeführt. Die erstgenannte Legierung wies dabei eine Permeabilität von ca. 8.000, die zweitgenannte Legierung wies eine Permeabilität von ca. 15.000 und die letztgenannte Legierung wies dabei eine Permeabilität von ca. 10.000 auf. turbereich gehalten und anschließend mit 0,1 - 5 K/min wieder auf Raumtemperatur abgekühlt. Aufgrund der Temperaturabhängigkeit der magnetischen Momente waren die erzielten Schleifen bei den Amorphlegierungen umso flacher und linearer, je niedriger die Querfeldtemperaturen waren. Die immer langsamere Kinetik bei der Reorientierung führte dabei auf eine legierungsspezifische Untergrenze, die im wesentlichen durch wirtschaftliche Gesichtspunkte, d.h. durch 48 stündige Glühungen, bestimmt war.

Aufgrund der entmagnetisierenden Felder im Inneren eines Kernstapels, die zu einer betragsmäßigen Schwächung und einer Divergenz der Feldlinien führen, waren besonders flache und lineare Schleifen nur dann erreichbar, wenn die Magnetkerne stirnseitig exakt so aufgestapelt waren, daß die Stapelhöhe mindestens das 10-fache, besser wenigstens das 20-fache des Kernaußendurchmessers betrug. Typische Kennlinien, die den linearen Charakter der hier realisierten Schleifen unterstreichen, sind der Fig. 4 zu entnehmen.

Fallweise kann auch auf ein Temperaturplateau im Querfeld verzichtet werden und die magnetische Vorzugsrichtung durch Abkühlen der Magnetkerne im Querfeld erzeugt werden. Das Permeabilitätsniveau wird dann über die Abkühlrate unterhalb der Curietemperatur des Magnetwerkstoffes eingestellt. Diese Art der Querfeldwärmebehandlung nach einer vorausgegangenen Entspannungsbehandlung eignet sich besonders gut zur Einstellung sehr hoher Permeabilitäten. Bei derart behandelten Magnetkernen können die normgerechten Frequenzeigenschaften durch Scherung mittels Einbringen eines Schlitzes in angepaßter Breite erreicht werden.

Als besonders geeignet haben sich bei hochpermeablen amorphen Legierungen, wobei im Folgenden unter hochpermeabel Permeabilitätswerte gemeint sind, die deutlich größer als 1.500 sind, Ebenso hat es sich als vorteilhaft erwiesen, bei extrem hochpermeablen nanokristallinen Legierungen, das heißt also bei nanokristallinen Legierungen, die Permeabilitäten von deutlich mehr als 20.000 aufwiesen die folgende spezielle Wärmebehandlung durchzuführen. Magnetkerne aus solchen nanokristallinen Legierungen werden zum Beispiel zunächst mit einer Aufheizrate zwischen ungefähr 1 und ungefähr 20 K/min. auf eine Zieltemperatur von ungefähr 450°C aufgeheizt, anschließend mit einer Aufheizrate zwischen ungefähr 0,1 und ungefähr 1 K/min. auf eine Temperatur von ungefähr 500°C weiter aufgeheizt und danach schließlich auf eine Zieltemperatur zwischen ca. 550°C und ca 580°C weiter aufgeheizt. Die Magnetkerne werden dann für eine Zeitdauer zwischen ungefähr 0,5 h und ungefähr 3 h bei dieser Zieltemperatur belassen. Anschließend werden die Magnetkerne mit einer Abkühlrate zwischen ca. 1 und ca. 10 K/min. auf eine Temperatur von ungefähr 360°C abgekühlt. Bei Erreichen dieser zweiten Zieltemperatur wird ein Querfeld mit einer Stärke von ungefähr 2.000 A/cm eingeschaltet und die Kerne bei dieser zweiten Temperatur für eine Zeitdauer zwischen ungefähr 2 h und ungefähr 6 h belassen. Anschließend wird unter Beibehaltung des Querfeldes mit einer Abkühlrate zwischen ca. 1 und ca. 10 K/min. auf Raumtemperatur wieder abgekühlt. Selbstverständlich sind wegen der außerordentlich hohen Permeabilität solche Magnetkerne wiederum über Schlitzen magnetisch zu scheren. Dieses Beispiel einer Wärmebehandlung ist in der Figur 8 dargestellt.

Zum Einbringen eines Schlitzes in den Magnetkern zur Einstellung von Höhe und Frequenzgang der effektiven Permeabilität $\mu_{eff}$ wurden verschiedene Verfahren erfolgreich untersucht. Zum Einbringen des Schlitzes erwiesen sich Funkenerosion, vorsichtiges Sägen z.B. mit Diamantsäge, Wasserstrahlschneiden oder Schneiden mittels einer feinen Trennscheibe als besonders günstig. Hierbei wurde beobachtet, daß die Qualität des Schnitts ganz entscheidend in den Frequenzgang der Permeabilität und damit der Einfügungsdämpfung eingeht. Mittels einer vor dem Schneiden durchgeführten Tränkung der Schnittzone mit einem dünnflüssigen Kunstharz, das aufgrund der Kapillarwirkung zwischen die Bandlagen des Kerns einzieht, wurden besonders hohe Schnittqualitäten erzielt. In diesen Fällen waren die in der Spaltzone auftretenden lokalen Verlustüberhöhungen vergleichsweise klein und demzufolge der Frequenzgang der Permeabilität wesentlich besser konstant als bei rauhen Schnittflächen.

Im Anschluß an die Wärmbehandlung und das Einbringen des Schlitzes werden die Magnetkerne oberflächlich passiviert, beschichtet, wirbelgesintert oder in einem Trog verkapselt, mit den Primär- bzw. Sekundärwicklungen versehen und gegebenenfalls im Bauelementgehäuse verklebt oder vergossen. Hierbei besteht auch die Möglichkeit, einen Aufbau in sogenannter Planartechnologie zu verwenden. Dieses Verfahren ist unabhängig davon, ob der Magnetkern aus amorphem oder nanokristallinem Material besteht. Aufgrund der Sprödigkeit hat allerdings die mechanische Handhabung der ausgetemperten nanokristallinen Magnetkerne mit besonderer Vorsicht zu erfolgen.

Eine weitere Fertigungsmöglichkeit ist, daß das Band zunächst einer Querfeldtemperung im Durchlauf unterzogen und anschließend zum Bandkern gewickelt wird. Der weitere Ablauf verläuft wie oben beschrieben.

Die mit diesen Verfahren hergestellten Magnetkerne erfüllen dann folgende Vorraussetzungen:

- Die Hauptinduktivität des bewickelten Ringbandkerns liegt je nach Auslegung der Filterdrossel im Bereich von 0.1 bis 2 mH, bei besonderen Ausführungsformen der Filter (z.B. elliptische Charakterisitik)ist die Hauptinduktivität auch < 100 $\mu$H.
- Die Hauptinduktivität erfüllt diesen Wert auch unter maximaler Wechselaussteuerung bei den normmäßig festgelegten Frequenzen.
- Der Linearitätsfehler der Hystereseschleife des Kerns ist so gering, daß gilt:

  $0,8 \leq \mu \, (B)/\mu \, (B=0) \leq 1,2$, vorzugsweise

  $0,9 \leq \mu \, (B)/\mu \, (B=0)$ s 1,1

  für $B = 0 - 0,8 \, B_S$

- Die in typischen Anwenderschaltungen erzielbaren Bitfehlerraten sind konform mit den Normen (ANSI T1E1.413 und ETSI ETR 328).
- Unter Verwendung amorpher und nanokristalliner Magnetwerkstoffe ergeben sich nach abgeglichener Querfeldtemperung für vorgegebene Werte der Hauptinduktivität z. B. die in Tab. 1 dargestellten typischen minimalen Kernabmessungen,

wobei die Abmessungen in der Reihenfolge Außendurchmesser, Innendurchmesser und Höhe angegeben sind.

Tab. 1

| $L_{haupt}$ [$\mu$H] | Kernabmessung [mm$^3$] | Kernmasse [g] | Werkstoff |
|---|---|---|---|
| | | | |
| 700 | 6.0*4.0*2.0 | 0.18 | $Fe_{88,2}Co_{1,8}Zr_7B_2Cu_1$ |
| 950 | 8.0*4.0*4.0 | 0.87 | $Fe_{73.5}Cu_1Nb_3Si_{15.5}B_7$ (nichtbeansprucht) |

Ähnliche Kernabmessungen ergeben sich auch beim Einsatz der anderen unten aufgezählten Legierungen, die anwendungsspezifisch eingesetzt werden.

Bei der Dimensionierung der induktiven Bauelemente sind eine Reihe von Zusammenhängen zu beachten.

Für die induktiven Bauelemente gilt der Zusammenhang

$$L \;=\; N^2 \mu_o \mu_r A_{fe}/l_{fe} \qquad\qquad (2)$$

L = Induktivität des Bauelements

N = Windungszahl

$\mu_o$ = universelle Permeabilitätskonstante

$\mu_r$ = Permeabilität des Materials

$A_{fe}$ = Eisenquerschnitt des Magnetkerns

$l_{fe}$ = Eisenweglänge des Magnetkerns.

Aus Gleichung (2) wird ersichtlich, daß die erforderliche Induktivität bei minimalem Bauvolumen nur dann

EP 1 188 235 B1

erreichbar ist, wenn Windungszahlen, Permeabilität, Kernquerschnitt und Eisenweglänge aufeinander abgestimmt sind. Die im gesamten Bereich der Arbeitsfrequenz gültige Permeabilität $\mu$ oder bei geschlitzten Ausführungsformen die effektive Permeabilität $\mu_{eff}$ des Kernmaterials ist neben der günstigen ringförmigen Geometrie der ausschlaggebende Parameter für eine möglichst kompakte Abmessung des Übertragers. Je nachdem welche der nachfolgend aufgezählten Legierungen zum Einsatz kommt und wie die zugehörige Wärmebehandlung geführt wird, läßt sich in definierter Weise ein Permeabilitätsbereich zwischen 500 und mehr als 100000 abdecken. Durch Einbringen eines Schlitzes in den Magnetkern läßt sich die Untergrenze der Permeabilität bis auf 100 oder sogar noch darunter verschieben. Für die induktiven Bauelemente des Hochpaßzweiges 7 kommt vorzugsweise der Permeabilitätsbereich $\mu$ oder $\mu_{eff}$ < 30000, insbesondere < 2500, zum Einsatz, was hinsichtlich der Dimensionierung der induktiven Bauelemente ein hohes Maß an Flexibilität mit sich bringt. Die mit diesen Magnetkernen realisierten induktiven Bauelemente für den Hochpaßzweig 7 besitzen aufgrund ihrer Bauform und der hohen Sättigungsinduktion der Magnetkerne gegenüber den geschlitzten Ferritkernen einen starken Volumenvorteil.

Bei der Auswahl des Kernwerkstoffes für die induktiven Bauelemente des Hochpaßzweiges 7 entsteht eine grundsätzliche Einschränkung dadurch, daß der Magnetkern durch die hohen Spannungsamplituden $U_{ac}$(ADSL) nicht bis in Sättigungsnähe aufmagnetisiert werden darf.

Die der Signalaussteuerung entsprechende Induktion ist durch

$$B_{ac} = (1/ N\ A_{fe})\ *\ \int U_{ac}\ dt \quad (3)$$

gegeben. Die Permeabilität und der Klirrfaktor dürfen bei dieser Signalaussteuerung nur sehr geringfügig abfallen. Aus diesem Grunde erfolgt die Beurteilung des Materials anhand von $\mu(B_{ac})$- und Klirrfaktor-Kennlinien.

Da der Klirrfaktor mit zunehmender Amplitude der magnetischen Induktion B ansteigt, muß die Legierungszusammensetzung in Kombination mit der Querfeldwärmebehandlung so festgelegt sein, daß einerseits die Sättigungsinduktion möglichst hoch, andererseits die Permeabilität unter einer von den Einsatzbedingungen abhängigen oberen Grenze liegt.

Eine niedrigere Permeabilität $\mu$ oder $\mu_{eff}$ hat eine Vergrößerung der Windungszahl N und damit bei vorgegebener Spannungsamplitude gemäß Gleichung (3) eine niedrigere Amplitude der magnetischen Induktion B zur Folge, was zu einem besseren Klirrfaktor führt.

Nachfolgend werden nun geeignete Legierungssysteme näher beschrieben. Es wurde herausgefunden, daß sich mit den nachfolgend beschriebenen Legierungssystemen unter Einhaltung der oben genannten Bedingungen induktive Bauelemente für Hochpaßzweige mit besonders linearen Hystereseschleifen und kleinen Bauformen herstellen lassen, die alle normgerechten Eigenschaften besitzen.

Bei den unten angeführten Legierungssystemen schließen die Kleiner-/Größerzeichen die Grenzen mit ein, alle at%-Angaben sind als ungefähr zu betrachten.

Legierungssystem 1: (nicht beansprucht)

Ein zweites Legierungssystem weist die Zusammensetzung $Fe_aCo_bCu_cSi_dB_eM_f$ auf, wobei M ein Element aus der Gruppe Nb, W, Ta, V, Zr, Hf, Ti, Mo oder eine Kombination aus diesen bezeichnet und a + b + c + d + e + f = 100 % ist, mit

| | | |
|---|---|---|
| Fe: | a = 100 % - b - c - d - e - f, | |
| Co: | b = 0-15 at% | vorzugsweise 0-0,5 at% |
| Cu: | c = 0,5 - 2 at%, | vorzugsweise 0,8 - 1,2 at%, |
| M: | f = 1 - 5 at%, | vorzugsweise 2 - 3 at%, |
| Si: | d = 6,5 - 18 at%, | vorzugsweise 14 - 17 at%, |
| B: | e = 5 - 14 at%. | |

wobei d + e > 18 at%, vorzugsweise d + e = 22 - 24 at% ist. Legierungen dieses Systems haben sich wegen ihrer linearen Schleifenform und ihres sehr guten Frequenzverhaltens für den ADSL-Hochpaßzweig 7 als sehr gut geeignet herausgestellt. Besonders gute ADSL-Hochpaßeigenschaften werden bei den als "vorzugsweise" hervorgehobenen Legierungszusammensetzungen erreicht, da hier, ebenso wie im Legierungssystem 1 ein Nulldurchgang der Sättigungsmagnetostriktion eingestellt werden kann. Dabei wurde auch hier herausgefunden, daß gerade die Kombination aus einem hohen spezifischen elektrischen Widerstand von 1,1 bis 1,2 $\mu\Omega$m und einer kleinen Banddicke zu einem ausgezeichneten Frequenzverhalten und damit hervorragenden Eigenschaften des ADSL-Hochpaßübertragers 9 und der Hochpaßfilter-

8

drossel 14 führt.

Daneben hat sich auch die mit $B_s$ = 1,1 - 1,3 T gemessene, vergleichsweise hohe Sättigungsinduktion bei extrem linearen Schleifen als sehr vorteilhaft erwiesen, da hierdurch hohe Induktionswerte von 1 T oder sogar mehr ausgesteuert werden können. Zusätzlich wurde gefunden, daß die Temperaturcharakteristik der Magnetkerne mittels der Wärmebehandlung zur Einstellung der Permeabilität gezielt angepaßt werden kann. Daraus können gerade bei rauhen Umweltbedingungen, wie sie in Telekommunikationseinrichtungen durchaus auftreten können, nicht anders realisierbare anwendungsspezifische Vorteile erwachsen. Bei Ringbandkernen mit höheren Permeabilitätswerten wurde zur Einstellung der normgerechten Eigenschaften auf eine Scherung mittels eines Schlitzes zurückgegriffen.

Legierungssystem 2:

Ein drittes für Hochpaßfilter geeignetes Legierungssystem hat die Zusammensetzung $Fe_xZr_yNb_zB_vCu_w$ , wobei $x + y + z + v + w$ = 100 at% ist, mit

    Fe: $x$ = 100 at% - $y$ - $z$ - $v$ - $w$, vorzugsweise 83 - 86 at%,
    Zr: $y$ = 2 - 5 at%, vorzugsweise 3 - 4 at%,
    Nb: $z$ = 2 - 5 at%, vorzugsweise 3 - 4 at%,
    B: $v$ = 5 - 9 at%,
    Cu: $w$ = 0,5 - 1,5 at%, vorzugsweise 1 at%,

wobei $y + z$ > 5 at%, vorzugsweise 6 - 7 at%,
und $y + z + v$ > 11 at%, vorzugsweise 12 - 16 at% ist.

Mit Legierungen dieses Systems konnten mit Querfeldwärmebehandlungen die legierungsspezifisch im Intervall zwischen 550 °C und 650 °C durchgeführt wurden, ebenfalls lineare Schleifenformen und ein gutes, für den ADSL-Hochpaßfilter 10 geeignetes Frequenzverhalten erzielt werden. Besonders günstig wirkt sich hier auf die Größe des Bauelements die hohe Sättigungsinduktion von ca. 1,5 bis 1,6 T aus.

Legierungssystem 3:

Ein weiteres geeignetes Legierungssystem hat die Zusammensetzung $Fe_xM_yB_zCu_w$ ,wobei M ein Element aus der Gruppe Zr, Hf, Nb bezeichnet und $x + y + z + w$ = 100 at% ist, mit

    Fe: $x$ = 100 at% - $y$ - $z$ - $w$, vorzugsweise 83 - 91 at%,
    M: $y$ = 6 - 8 at%, vorzugsweise 7 at%,
    B: $z$ = 3 - 9 at%,
    Cu: $w$ = 0 - 1,5 at%.

Mit Legierungen dieses Systems konnten die Grundvoraussetzung $|\lambda_s|$ < 1 ppm erfüllt werden. Die mit den durchgeführten Querfeldbehandlungen zwischen 550 °C und 650 °C legierungsspezifisch erreichten Permeabilitäten lagen vergleichsweise niedrig zwischen 2000 und 15000. Die für den ADSL-Hochpaßfilter 10 notwendigen Linearitätsanforderungen wurden dabei vor allem im oberen Bereich der Querfeldtemperaturen befriedigt. Aufgrund der hohen Sättigungsinduktion von 1,4 bis 1,5 T konnten sehr kleine Bauformen realisiert werden.

Legierungssystem 4:

Ein fünftes Legierungssystem weist schließlich die Zusammensetzung $(Fe_{0,98}Co_{0,02})_{90-X}Zr_7B_{2+X}Cu_1$ auf mit $x$ = 0 - 3, vorzugsweise $x$ = 0 auf, wobei bei entsprechendem Abgleich der restlichen Legierungsbestandteile Co durch Ni ersetzbar ist.

Bei diesem System wurde bei legierungsspezifisch abgestimmter Querfeldwärmebehandlung ein Nulldurchgang in der Sättigungmagnetostriktion erreicht, der zu besonders linearen Hystereseverläufen führte. Dadurch wurden die Frequenzgänge der komplexen Permeabilität so stark verbessert, daß sie denen der Legierungssystemen 1 und 2 sehr nahe kommen. Als herausragender Vorteil erwies sich bei diesem System die hohe Sättigungsinduktion, die mit Werten von $B_s$= 1,65 bis 1,75 T gemessen wurde. Durch die besonders günstige Kombination aus annähernder Magnetostriktionsfreiheit und hoher Sättigungsinduktion konnten hier verzerrungsarm nutzbare Induktionsamplituden bis zu 1,5 Tesla und mehr realisiert werden, wodurch besonders kleine Bauformen, die sowohl für die ADSL-Hochpaßfilterdrosseln 14 als auch für die ADSL-Hochpaß-Übertrager 9 genutzt werden sollen, möglich werden.

Die Legierungssysteme 1 bis 4 erhalten nach der Wärmebehandlung eine feinkristalline Struktur mit Korndurchmessern unter 100 nm. Diese Körner sind von einer amorphen Phase umgeben, die allerdings weniger als 50 % des Materialvolumens einnimmt.

Sämtliche Legierungssysteme 1 bis 4 zeichnen sich durch die folgenden Eigenschaften aus:

- extrem lineare Hystereseschleife;
- Betrag der Sättigungsmagnetostriktion $|\lambda_s|$ < 2 ppm, vorzugsweise < 0,1 ppm nach der Wärmebehandlung. Bei den Kobalt-Basis-Amorphwerkstoffen kann die Sättigungsmagnetostriktion dadurch eingestellt werden, daß der Fe und Mn-Gehalt entsprechend feinangepaßt wird. Bei den nanokristallinen Legierungen kann der Sättigungsmagnetostriktion über die Größe des feinkristallinen Korns eingestellt werden, was durch eine gezielte Abstimmung der Wärmebehandlung, des Metalloidgehaltes und des Gehaltes an Refraktärmetallen bewerkstelligt werden kann.
- Sättigungsinduktion von 0,6 T bis 1,7 T, wobei die Sättigungsinduktion durch Wahl des Gehaltes an Ni, Co, M, Si, B und C feinabgestimmt werden kann.
- Bänder, deren Dicken weniger als 17 $\mu$m betragen können;
- Hoher spezifischer elektrischer Widerstand, der bis zu 1,5 $\mu\Omega$m betragen kann.

Die oben genannten Anforderungen und Legierungsbereiche werden nach Durchführung der beschriebenen Wärmebehandlung z.B. durch die in Tabelle 2 aufgeführten Legierungsbeispiele eingehalten bzw. erfüllt.

Tab. 2

| Legierungs-zusammensetzung [at %] | Struktur | Sättig.-induktion [T] | Anisotropie-feldstärke $H_a$ [A/cm] | Sättigungsmagnetostriktion $\lambda_s$ | |
|---|---|---|---|---|---|
| | | | | as quenched | wärmebehandelt |
| $(Fe_{0,98}Co_{0,02})_{90}Zr_7B_2Cu_1$ | nanokr. | 1,70 | 1,7 | - | $-1,0*10^{-7}$ |
| $Fe_{84}Zr_{3,5}Nb_{3,5}B_8Cu_1$ | nanokr. | 1,53 | 0,8 | $+3*10^{-6}$ | $+1,5*10^{-7}$ |

Die in Tabelle 2 aufgeführten amorphen, fein- oder nanokristallinen Legierungen zeichnen sich durch besonders hohe Werte der Sättigungsinduktion von bis zu 1,7 Tesla aus. Diese lassen vergleichsweise hohe Permeabilitätswerte zu, wodurch gegenüber Ferritübertragern weitere Vorteile hinsichtlich Baugröße und Bewicklung entstehen.

Bezugszeichenliste

1 Ortsvermittlungsstelle
2 Netzabschluß
3 öffentliche Zweidrahtleitung
4 Filterweichen
5 ADSL-Zweig
6 ISDN-/POTS-Zweig
7 Hochpaßzweig
8 Tiefpaßzweig
9 Hochpaßübertrager
10 Hochpaßfilterkomponenten
11 Spulen
12 Kondensator
13 Kondensator
14 Hochpaßfilterdrossel

**Patentansprüche**

**1.** ADSL Frequenzweiche mit einem Tiefpaßzweig (8) für niederfrequente Signale insbesondere analoger Kommunikationssysteme und einem Hochpaßzweig (7) für hochfrequente Signale digitaler Kommunikationssysteme mit einer Vielzahl von induktiven Bauelementen (11, 14) mit Magnetkernen,
**dadurch gekennzeichnet,**
**dass** der Hochpaßzweig (7) wenigstens ein Bauelement (11, 14) mit einem Magnetkern aus einer nanokristallinen Legierung umfasst und

**dass** die Legierung die Zusammensetzung $Fe_xZ-r_yNb_2B_vCu_w$ aufweist, wobei $x + y + z + v + w = 100$ at% ist, mit

Fe: x = 100 at% - y - z - v - w ,
Zr: y = 2 - 5 at%,
Nb: z = 2 - 5 at%,
B: v = 5 - 9 at%,
Cu: W = 0,5 - 1,5 at%,

wobei y + z > 5 at% und y + z + v > 11 gilt.

2. ADSL-Frequenzweiche nach Anspruch 1,
**dadurch gekennzeichnet,**
**dass** die Beziehungen gelten:

Fe: x = 83 - 86 at%,
Zr: y = 3 - 4 at%,
Nb: z = 3 - 4 at%,
B: v = 5 - 9 at%,
Cu: w = 1 at%,

wobei y + z = 6 - 7 at%,
und y + z + v > 12 - 16 at%.

3. ADSL Frequenzweiche mit einem Tiefpaßzweig (8) für niederfrequente Signale insbesondere analoger Kommunikationssysteme und einem Hochpaßzweig (7) für hochfrequente Signale digitaler Kommunikationssysteme mit einer Vielzahl von induktiven Bauelementen (11, 14) mit Magnetkernen,
**dadurch gekennzeichnet,**
**dass** der Hochpaßzweig (7) wenigstens ein Bauelement (11, 14) mit einem Magnetkern aus einer amorphen oder nanokristallinen Legierung umfasst und
**dass** die Legierung die Zusammensetzung $Fe_xM_yB_zCu_w$ aufweist, wobei M ein Element aus der Gruppe Zr, Hf, Nb bezeichnet und $x + y + z + w = 100$ at% ist, mit

Fe: x = 100 at% - y - z - w,
M: y = 6 - 8 at%,
B: z = 3 - 9 at%,
Cu: w = 0 - 1,5 at%

4. ADSL - Frequenzweiche nach Anspruch 3,
**dadurch gekennzeichnet,**
**dass** die Beziehungen gelten:

Fe: x = 83 - 91 at%,
M: y = 7 at%,
B: z = 3 - 9 at%,
Cu: w = 0 - 1 , 5 a t %

5. ADSL Frequenzweiche mit einem Tiefpaßzweig (8) für niederfrequente Signale insbesondere analoger Kommunikationssysteme und einem Hochpaßzweig (7) für hochfrequente Signale digitaler Kommunikationssysteme mit einer Vielzahl von induktiven Bauelementen (11, 14) mit Magnetkernen,
**dadurch gekennzeichnet,**
**dass** der Hochpaßzweig (7) wenigstens ein Bauelement (11, 14) mit einem Magnetkern aus einer amorphen oder nanokristallinen Legierung umfasst und
**daß** die Legierung die Zusammensetzung
$(Fe_{0i98}Co_0.o2\}90-xZr_7B_2+xCui$ aufweist mit x = 0 - 3, wobei bei entsprechendem Abgleich der restlichen Legierungsbestandteile Co durch Ni ersetzbar ist.

6. Frequenzweiche nach Anspruch 5,
**dadurch gekennzeichnet,**

**dass** x = O ist.

**Claims**

1. ADSL frequency separating filter with a low-pass branch (8) for low-frequency signals, in particular of analog communication systems, and a high-pass branch (7) for high-frequency signals of digital communication systems, with a multiplicity of inductive components (11, 14) with magnet cores, **characterized in that** the high-pass branch (7) comprises at least one component (11, 14) with a magnet core of a nanocrystalline alloy and **in that** the alloy has the composition $Fe_xZr_yNb_zB_vCu_w$, where $x + y + z + v + w = 100$ atomic %, with
   Fe: x = 100 atomic % - y - z - v - w,
   Zr: y = 2 - 5 atomic %,
   Nb: z = 2 - 5 atomic %,
   B: v = 5 - 9 atomic %,
   Cu: w = 0.5 - 1.5 atomic %,
   where y + z > 5 atomic % and y + z + v > 11.

2. ADSL frequency separating filter according to Claim 1, **characterized in that** the following relations apply:
   Fe: x = 83 - 86 atomic %,
   Zr: y = 3 - 4 atomic %,
   Nb: z = 3 - 4 atomic %,
   B: v = 5 - 9 atomic %,
   Cu: w = 1 atomic %,
   where y + z = 6 - 7 atomic %,
   and y + z + v > 12 - 16 atomic %.

3. ADSL frequency separating filter with a low-pass branch (8) for low-frequency signals, in particular of analog communication systems, and a high-pass branch (7) for high-frequency signals of digital communication systems, with a multiplicity of inductive components (11, 14) with magnet cores, **characterized in that** the high-pass branch (7) comprises at least one component (11, 14) with a magnet core of an amorphous or nanocrystalline alloy and **in that** the alloy has the composition $Fe_xM_yB_zCu_w$, where M is an element from the group Zr, Hf, Nb and $x + y + z + w = 100$ atomic %, with
   Fe: x = 100 atomic % - y - z - w,
   M: y = 6 - 8 atomic %,
   B: z = 3 - 9 atomic %,
   Cu: w = 0 - 1.5 atomic %.

4. ADSL frequency separating filter according to Claim 3, **characterized in that** the following relations apply:
   Fe: x = 83 - 91 atomic %,
   M: y = 7 atomic %,
   B: z = 3 - 9 atomic %,
   Cu: w = 0 - 1.5 atomic %.

5. ADSL frequency separating filter with a low-pass branch (8) for low-frequency signals, in particular of analog communication systems, and a high-pass branch (7) for high-frequency signals of digital communication systems, with a multiplicity of inductive components (11, 14) with magnet cores, **characterized in that** the high-pass branch (7) comprises at least one component (11, 14) with a magnet core of an amorphous or nanocrystalline alloy and **in that** the alloy has the composition $(Fe_{0.98}Co_{0.02})_{90-X}Zr_7B_{2+X}Cu_1$ with x = 0 - 3, where Co can be substituted by Ni if the remaining alloying constituents are correspondingly adjusted.

6. Frequency separating filter according to Claim 5, **characterized in that** x = 0.

**Revendications**

1. Diplexeur ADSL avec une branche passe-bas (8) pour les signaux basse fréquence, en particulier de systèmes de communication analogiques, et une branche passe-haut (7) pour signaux haute fréquence de systèmes de communication numériques, comportant une pluralité de composants inductifs (11, 14) avec tores magnétiques,

**caractérisé en ce que**

la branche passe-haut (7) comprend au moins un composant (11, 14) avec un tore magnétique en un alliage nanocristallin, et

l'alliage présente la composition $Fe_xZr_yNb_zB_vCu_w$, dans laquelle $x + y + z + v + w = 100$ at%, avec

Fe : $x = 100$ at% - y - z - v - w,

Zr : $y = 2 - 5$ at%,

Nb : $z = 2 - 5$ at%

B : $v = 5 - 9$ at%,

Cu : $w = 0,5 - 1,5$ at%,

$y + z > 5$ at% et $y + z + v > 11$ at%.

2. Diplexeur selon la revendication 1,
   **caractérisé en ce que**
   les équations valables sont :
   Fe : $x = 83 - 86$ at%,
   Zr : $y = 3 - 4$ at%,
   Nb : $z = 3 - 4$ at%,
   B : $v = 5 - 9$ at%,
   Cu : $w = 1$ at%,
   $y + z = 6 - 7$ at%,
   et $y + z + v > 12 - 16$ at%.

3. Diplexeur ADSL avec une branche passe-bas (8) pour les signaux basse fréquence, en particulier de systèmes de communication analogiques, et une branche passe-haut (7) pour signaux haute fréquence de systèmes de communication numériques, comportant une pluralité de composants inductifs (11, 14) avec tores magnétiques,
   **caractérisé en ce que**
   la branche passe-haut (7) comprend au moins un composant (11, 14) avec un tore magnétique en un alliage amorphe ou nanocristallin, et
   que l'alliage présente la composition $Fe_xM_yB_zCu_w$, dans laquelle M désigne un élément du groupe Zr, Hf, Nb et $x + y + z + w = 100$ at%, avec
   Fe : $x = 100$ at% - y - z - w,
   M : $y = 6 - 8$ at%,
   B : $z = 3 - 9$ at%,
   Cu : $w = 0 - 1,5$ at%.

4. Diplexeur selon la revendication 3,
   **caractérisé en ce que**
   les équations valables sont :
   Fe : $x = 83 - 91$ at%,
   M : $y = 7$ at%
   B : $z = 3 - 9$ at%,
   Cu: $w = 0 - 1,5$ at%

5. Diplexeur ADSL avec une branche passe-bas (8) pour les signaux basse fréquence, en particulier de systèmes de communication analogiques, et une branche passe-haut (7) pour signaux haute fréquence de systèmes de communication numériques, comportant une pluralité de composants inductifs (11, 14) avec tores magnétiques,
   **caractérisé en ce que**
   la branche passe-haut (7) comprend au moins un composant (11, 14) avec un tore magnétique en un alliage amorphe ou nanocristallin et l'alliage présente la composition $(Fe_{o,98}Co_{0,02})_{90-x}Zr_7B_{2+x}Cu_1$ avec $x = 0 - 3$, Co pouvant être remplacé par Ni lorsque les composants restants de l'alliage sont équilibrés de façon adéquate.

6. Diplexeur selon la revendication 5,
   **caractérisé en ce que**
   $x = 0$.

# FIG 1

# FIG 2

FIG 3

# FIG 4

EP 1 188 235 B1

## FIG 5

EP 1 188 235 B1

FIG 6

FIG 7

FIG 8